Europäisches Patentamt

European Patent Office

Office européen des brevets

(19)

(11) **EP 1 439 399 A2**

(12) **EUROPÄISCHE PATENTANMELDUNG**

(43) Veröffentlichungstag:
**21.07.2004 Patentblatt 2004/30**

(51) Int Cl.⁷: **G01R 31/36**

(21) Anmeldenummer: 03025647.3

(22) Anmeldetag: **07.11.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **17.01.2003 DE 10301529**

(71) Anmelder: **ROBERT BOSCH GMBH**
**70442 Stuttgart (DE)**

(72) Erfinder:
- **Frey, Wunibald**
 **71701 Schweiberdingen (DE)**
- **Meyer, Helmut**
 **70839 Gerlingen (DE)**
- **Knapp, Marc**
 **71729 Erdmannhausen (DE)**

(54) **Verfahren und Vorrichtung zur Ermittlung des Zustands einer Fahrzeugbatterie**

(57) Die Erfindung betrifft ein Verfahren und eine Vorrichtung zur Ermittlung des Zustands einer Fahrzeugbatterie, wobei eine Messung der Batteriespannung erfolgt und wobei aus der gemessenen Batteriespannung mittels eines Integrationsvorganges Informationen über den Zustand der Fahrzeugbatterie abgeleitet werden. Beim Integrationsvorgang wird ein variabler Gewichtungsfaktor berücksichtigt.

FIG 1

EP 1 439 399 A2

**Beschreibung**

Die Erfindung betrifft ein Verfahren und eine Vorrichtung zur Ermittlung des Zustands einer Fahrzeugbatterie.

Stand der Technik

Zur Erhöhung der Verfügbarkeit in Bordnetzen mit hohem Anspruch an eine permanente Energieversorgung ist es bereits bekannt, Bordnetztopologien mit Hilfsbatterie einzusetzen. Über ein elektronisches Batteriemanagement wird der Zustand der Hauptbatterie vergleichsweise aufwendig ermittelt und abhängig von einem konstanten Schwellenwert die Hilfsbatterie zugeschaltet. Zur Ermittlung des Batteriezustandes wird in der Regel der Batteriestrom, die Batteriespannung und die Batterietemperatur verwendet.

Aus der DE 198 45 562 Cl ist ein Verfahren zur Ermittlung des Bordnetzzustandes eines Kraftfahrzeugs unter Verwendung der Messung der Batteriespannung bekannt. Dabei wird die Batteriespannung über einen längeren Zeitraum gemittelt. Ein kritischer Zustand wird erkannt, wenn eine definierte Spannungsschwelle unterschritten wird.

Vorteile der Erfindung

Ein Verfahren mit den im Anspruch 1 angegebenen Merkmalen hat demgegenüber den Vorteil einer genaueren Ermittlung des Zustands der Fahrzeugbatterie. Durch die Berücksichtigung eines variablen Gewichtungsfaktors bei der Ermittlung des Zustands einer Fahrzeugbatterie können kurzzeitige Ereignisse und Langzeiteffekte, die bei Nichtberücksichtigung zu ungenauen oder gar falschen Aussagen über den Zustand der Fahrzeugbatterie führen würden, in angemessener Weise berücksichtigt werden. Ein Beispiel für ein kurzzeitiges Ereignis ist ein auftretender Lastsprung, der zu einem kurzfristigen Spannungseinbruch führt. Ein Beispiel für einen Langzeiteffekt ist die Alterung der Fahrzeugbatterie.

Weitere Vorteile der Erfindung bestehen darin, dass die Ermittlung des Zustands einer Fahrzeugbatterie in einfacher und kostenreduzierter Weise erfolgt.

Aufgrund der genaueren Ermittlung des Zustands der Fahrzeugbatterie wird auch die Arbeitsweise eines elektrischen Energiemanagements, welchem die ermittelte Information über den Zustand der Fahrzeugbatterie zugeführt wird, verbessert. Weiterhin wird bei Bordnetztopologien, die eine Hilfsbatterie verwenden, die Zuschaltung der Hilfsbatterie optimiert.

Ein weiterer Vorteil der Erfindung besteht darin, dass das beanspruchte Verfahren keine aufwendige Erfassung des Batteriestroms benötigt.

Vorzugsweise wird der Gewichtungsfaktor gemäß der im Anspruch 3 angegebenen Beziehung berechnet. Dadurch kann die Genauigkeit der Ermittlung des Zustands einer Fahrzeugbatterie durch Berücksichtigung einer Vielzahl verschiedener Statusinformationen verbessert werden.

Die Vorteile des im Anspruch 6 angegebenen Verfahrens bestehen insbesondere in einer einfachen und preisgünstigen Realisierung.

Weitere vorteilhafte Eigenschaften der Erfindung ergeben sich aus der nachfolgenden Beschreibung anhand der Figuren.

Zeichnung

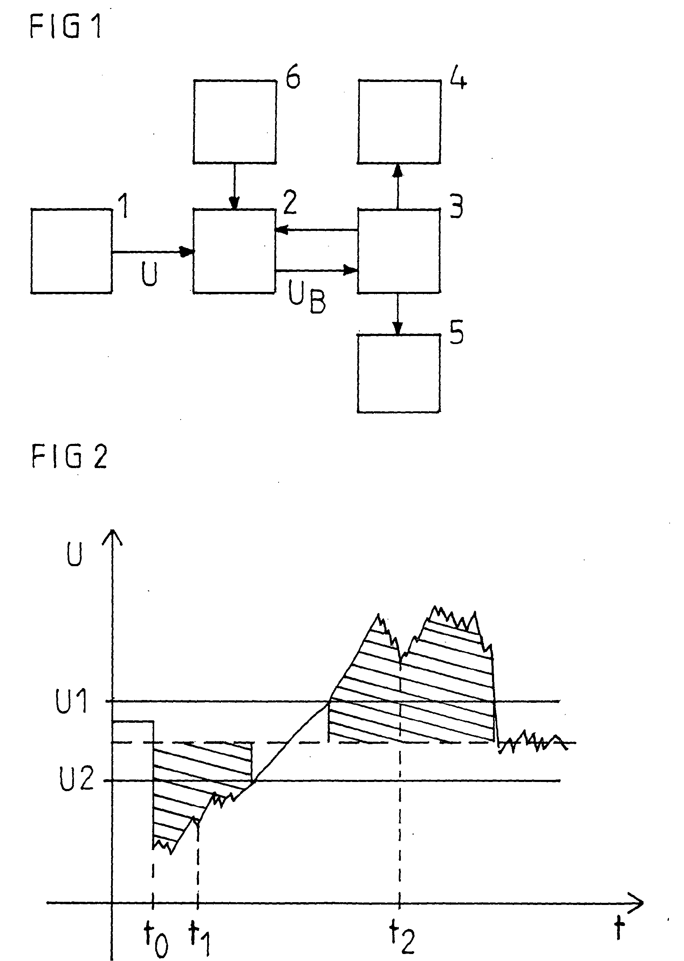

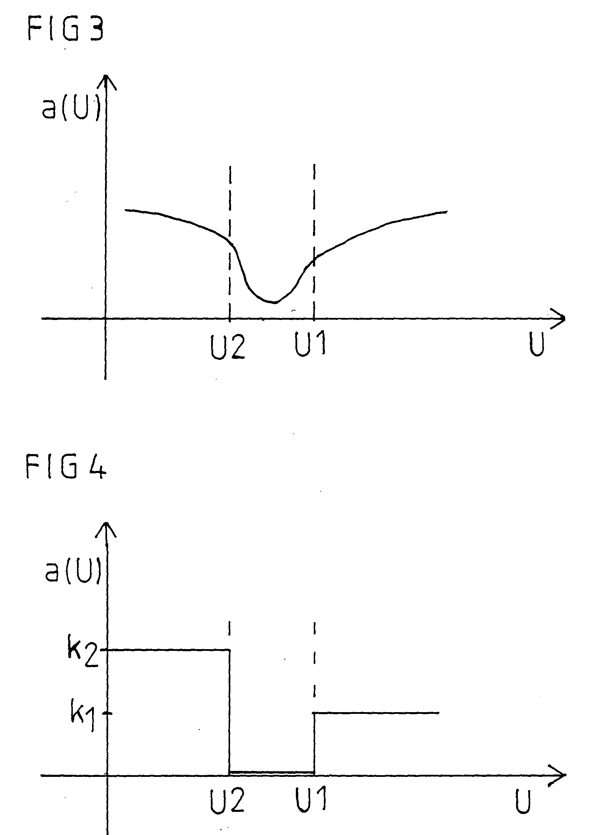

Die Figur 1 zeigt ein Blockschaltbild einer Vorrichtung zur Ermittlung des Zustands einer Fahrzeugbatterie. Die Figur 2 zeigt eine Skizze zur Veranschaulichung der Funktionsweise einer Vorrichtung gemäß einem ersten Ausführungsbeispiel für die Erfindung. Die Figur 3 zeigt eine Skizze zur Veranschaulichung der Funktionsweise einer Vorrichtung gemäß einem zweiten Ausführungsbeispiel für die Erfindung. Die Figur 4 zeigt eine Skizze zur Veranschaulichung der Funktionsweise einer Vorrichtung gemäß einem dritten Ausführungsbeispiel für die Erfindung.

Beschreibung

Die Figur 1 zeigt ein Blockschaltbild einer Vorrichtung zur Ermittlung des Zustands einer Fahrzeugbatterie. Diese Vorrichtung weist einen Spannungsmesser 1 auf, der zur Messung der Batteriespannung vorgesehen ist. Die Ausgangssignale des Spannungsmessers 1 werden einer Auswerteeinheit 2 zugeführt, die unter Verwendung der ihr vom Spannungsmesser 1 zugeführten Signale und vorzugsweise unter Verwendung weiterer Signale an ihrem Ausgang ein den Zustand der Fahrzeugbatterie beschreibendes Signal $U_B$ zur Verfügung stellt. Die genannten weiteren Signale werden nachfolgend auch als Statusinformationen bezeichnet. Das Signal $U_B$ wird dem Energiemanagement 3 des Fahrzeugs zugeführt. Das Energiemanagement 3 ist dazu vorgesehen, das im Fahrzeug verfügbare Energieangebot und den Energieverbrauch zu beeinflussen.

Signalisiert das dem Energiemanagement 3 zugeführte Signal $U_B$ das Vorliegen eines schlechten Zustands der Fahrzeugbatterie, dann leitet der Energiemanager 3 geeignete Gegenmaßnahmen zur Verbesserung der Ladebilanz der Fahrzeugbatterie in die Wege, um ein Weiterarbeiten der sicherheitsrelevanten Komponenten des Fahrzeugs sicherzustellen. Zu diesen sicherheitsrelevanten Komponenten gehören beispielsweise eine elektrohydraulische Bremse und die Servolenkung des Fahrzeugs. Die geeigneten Gegenmaßnahmen bestehen darin, dass das Energiemanagement 3 einen Schalter 4 schließt, um eine Hilfsbatterie zuzuschalten. Zusätzlich dazu oder alternativ dazu stellt das Energiemanagement 3 auch einer weiteren Schalteinheit 5 Steuersignale zur Verfügung, mittels welcher zum Zwecke einer Reduzierung des Energieverbrauchs nicht sicherheitsrelevante Verbraucher des Fahrzeugs abgeschaltet oder zumindest in ihrem Leistungsverbrauch reduziert werden. Zu diesen nicht sicherheitsrelevanten Verbrauchern gehört beispielsweise die Heckscheibenheizung des Fahrzeugs und die Sitzheizung.

Die weiteren Signale, die die Auswerteeinheit 2 zur Ermittlung des den Zustand der Fahrzeugbatterie beschreibenden Signals $U_B$ vorzugsweise verwendet, werden der Auswerteeinheit 2 beispielsweise von einem Informationsgeber 6 und/oder dem Energiemanagement 3 zur Verfügung gestellt. Es handelt sich dabei um weitere verfügbare Informationen aus dem Bordnetz. Zu diesen weiteren Informationen gehören Informationen über die Temperatur der Batterie, Informationen über den Energiezustand des Fahrzeugs, Informationen über im Bordnetz auftretende Lastsprünge, Informationen über auftretende Spannungseinbrüche, Informationen über den Batteriestrom und Informationen über die Ruhespannung. Die genannten Informationen werden der Auswerteeinheit 2 über den CAN-Bus des Fahrzeugs zugeleitet. Sie können auch von der jeweiligen Informationsquelle aus direkt oder über andere Buskonfigurationen der Auswerteeinheit 2 zugeführt werden.

Nachfolgend werden anhand der Figuren 2 - 4 Ausführungsbeispiele für die Erfindung näher erläutert.

Die Figur 2 zeigt eine Skizze zur Veranschaulichung der Funktionsweise einer Vorrichtung gemäß einem ersten Ausführungsbeispiel für die Erfindung. Bei diesem ersten Ausführungsbeispiel wird die vom Spannungsmesser 1 gemessene Batteriespannung U der Auswerteeinheit 2 zugeführt. Die Auswerteeinheit 2 weist einen Integrator auf. Dieser wird nach jedem Fahrzeugstart, nachdem eine Initialisierung durchgeführt wurde und eine Batterieruhestromauswertung erfolgt ist, gestartet. Er berechnet ein Spannungsintegral L(t), welches Auskunft über die Ladebilanz der Fahrzeugbatterie gibt, gemäß der folgenden Beziehung:

$$L(t) = \int_{t_o}^{t} D(\tau) \bullet a[U(\tau)]d\tau.$$

Dabei ist D(T) eine Differenzfunktion, die wie folgt lautet:

$$D(\tau) = U(\tau) - \frac{U1 + U2}{2}.$$

U1 ist ein vorgegebener oberer Spannungsschwellenwert, U2 ein vorgegebener unterer Spannungsschwellenwert. Diese Spannungsschwellenwerte werden in Abhängigkeit von der jeweiligen Applikation vorgegeben.

Liegt ein gemessener Spannungswert unterhalb des unteren Spannungsschwellenwertes U2, dann wird die Batterie entladen. Dabei wird im Sinne einer Vereinfachung angenommen, dass die Höhe der Spannung ein Maß für den Entladestrom der Fahrzeugbatterie darstellt. Die Spannungen in diesem Bereich leisten daher einen negativen Beitrag bei der Integralbildung. Beispielsweise gilt:

$$D(t_1) = U(t_1) - \frac{U1 + U2}{2} < 0.$$

Der Gewichtungsfaktor a $[U(\tau)]$ hat für gemessene Spannungswerte, die unterhalb des unteren Spannungsschwellenwertes U2 liegen, den Wert 1.

Liegt ein gemessener Spannungswert zwischen den beiden Spannungsschwellenwerten U1 und U2, dann ist nicht definitiv festgelegt, ob gerade eine Ladung oder eine Entladung der Batterie erfolgt. Da die in diesem Spannungsbereich auftretenden Lade- und Entladeströme klein sind, sind sie ohne großen Einfluss auf den Ladezustand der Fahrzeugbatterie. Dieser Spannungsbereich wird bei der Integralbildung ausgeblendet. Dies geschieht dadurch, dass der Gewichtungsfaktor a$[U(\tau)]$ in diesem Spannungsbereich zu Null gesetzt wird.

Liegt ein gemessener Spannungswert oberhalb des oberen Spannungsschwellenwertes U1, dann wird die Batterie geladen. Dabei wird im Sinne einer Vereinfachung angenommen, dass die Höhe der Spannung ein Maß für den Ladestrom der Fahrzeugbatterie ist. Die Spannungen in diesem Bereich leisten daher einen positiven Beitrag bei der Integralbildung. Beispielsweise gilt:

$$D(t_2) = U(t_2) - \frac{U1 + U2}{2} > 0.$$

Der Gewichtungsfaktor a[U($\tau$)] hat für gemessene Spannungswerte, die oberhalb des oberen Spannungsschwellenwertes U1 liegen, den Wert 1.

Nach alledem ist der Gewichtungsfaktor a[U($\tau$)] variabel. Er ist von der gemessenen Batteriespannung abhängig, wobei folgende Gesamtbeziehung gilt:

$$a(U) = \begin{array}{l} 0 \text{ für } U2 \leq U \leq U1 \\ 1 \text{ für } U2 > U \text{ oder } U1 < U. \end{array}$$

Das ermittelte Spannungsintegral L wird in der Auswerteeinheit 2 mit einem vorgegebenen Grenzwert G verglichen. Unterschreitet das ermittelte Spannungsintegral L diesen Grenzwert, dann generiert die Auswerteeinheit 2 ein Ladezustandssignal U_B, welches dem Energiemanagement 3 signalisiert, dass der Ladezustand der Fahrzeugbatterie unzureichend ist. Das Energiemanagement 3 leitet daraufhin Maßnahmen zur Verbesserung der Ladebilanz in die Wege. Beispielsweise wird ein Schalter 4 geschlossen, um eine Hilfsbatterie zuzuschalten. Alternativ dazu oder zusätzlich dazu kann das Energiemanagement 3 auch Steuersignale für die Schalteinheit 5 erzeugen, wodurch nicht sicherheitsrelevante Verbraucher des Fahrzeugs abgeschaltet werden oder deren Leistungsverbrauch reduziert wird.

Liegt das ermittelte Spannungsintegral L oberhalb des Grenzwertes G, dann bleibt die Hilfsbatterie abgeschaltet und die nicht sicherheitsrelevanten Verbraucher bleiben - sofern sie gerade aktiviert sind - in Betrieb.

Die Figur 3 zeigt eine Skizze zur Veranschaulichung der Funktionsweise einer Vorrichtung gemäß einem zweiten Ausführungsbeispiel für die Erfindung. Bei diesem zweiten Ausführungsbeispiel geht im Unterschied zum ersten Ausführungsbeispiel in den Gewichtungsfaktor a weiterhin die Abhängigkeit des Batteriestroms von der aktuellen Spannung ein. Folglich ist der Gewichtungsfaktor a im Unterschied zum ersten Ausführungsbeispiel nicht mehr abschnittsweise konstant, sondern hat beispielsweise einen Verlauf, wie er in der Figur 3 dargestellt ist. Ziel bei diesem Ausführungsbeispiel ist es, mit dem Ausdruck D(t) • a[U(t)] die Funktion i(Batt) = I(t)
möglichst genau zu treffen.

Auch bei diesem Ausführungsbeispiel wird die ermittelte Information U_B über den Ladezustand der Fahrzeugbatterie im Energiemanagement 3 umgesetzt in Steuersignale für den Schalter 4 und/oder die Schalteinheit 5.

Die Figur 4 zeigt eine Skizze zur Veranschaulichung der Funktionsweise einer Vorrichtung gemäß einem dritten Ausführungsbeispiel für die Erfindung. Bei diesem dritten Ausführungsbeispiel erfolgt eine Kalibrierung des variablen Gewichtungsfaktors a durch eine Ladezustandsbestimmung unter Verwendung einer Ruhespannungsmessung. Dabei werden verschiedene Formparameter, die in den Gewichtungsfaktor eingehen, unter Verwendung von Korrekturdaten, die nach einem Fahrzeugstart gewonnen werden, dynamisch angepasst. Dies führt dazu, dass die unter Verwendung einer Integralbildung erfolgende Ladebilanzbestimmung sich mit der Zeit im Sinne einer Selbstadaption stets verbessert.

Bei diesem Ausführungsbeispiel gilt allgemein die folgende Beziehung:

$$a(U) = a(k_1, k_2, ..., k_n; U).$$

Der Gewichtungsfaktor a ist folglich abhängig von der gemessenen Spannung U und einer Vielzahl von Vor-faktoren $k_1, k_2, ..., k_n$.

Es gilt:

$$a(U) = k_1 \bullet a_1(U) + k_2 \bullet a_2(U) + \bullet\bullet\bullet + k_n \bullet a_n =$$

$$= \sum_{i=1}^{n} k_i \bullet a_i(U).$$

Dabei wird jeder der Vorfaktoren $k_i$ selbst adaptiv bestimmt und ist von mehreren Parametern abhängig:

$$k_i = k_i(\tau; \vartheta; ...).$$

In der Figur 4 ist ein einfaches Ausführungsbeispiel veranschaulicht, bei welchem angenommen ist, dass in die Berechnung des Gewichtungsfaktors lediglich zwei Gewichtsfunktionen $a_1(U)$ und $a_2(U)$ eingehen, wobei jeder dieser Gewichtsfunktionen ein Vorfaktor $k_1$ bzw. $k_2$ zugeordnet ist. Gemäß diesem einfachen Ausführungsbeispiel gilt:

$$a(U) = k_1 \bullet a_1(U) + k_2 \bullet a_2(U).$$

Weiterhin wurde bei diesem vereinfachten Ausführungsbeispiel angenommen, dass eine abschnittsweise Konstanz vorliegt, wie sie aus der Figur 4 ersichtlich ist.
Generell können bei diesem Ausführungsbeispiel beliebige Vorfaktoren $k_i$ für die unterschiedlichen Gewichtsfunktionen verwendet werden. Diese Vorfaktoren sind variabel und können durch eine Eichung und durch andere verfügbare Informationen wie Statusinformationen aus dem elektrischen Energiemanagement, Informationen über Lastsprünge und Informationen über Spannungseinbrüche im Bordnetz gewonnen werden. In der Praxis ist es sinnvoll, sich auf zwei oder drei in Abhängigkeit von der jeweils vorliegenden Applikation gewählte Gewichtsfunktionen und'die zugehörigen Vorfaktoren zu beschränken.
Beispiele für derartige Gewichtsfunktionen sind:

$$a_1(U) = \text{sign}(U - US) + 1,$$

$$a_2(U) = \text{sign}(U - US) - 1,$$

wobei

$$\text{sign}(x) = \begin{array}{l} -1 \ \text{für } x < 0 \\ \phantom{-}0 \ \text{für } x = 0 \\ \phantom{-}1 \ \text{für } x > 0; \end{array}$$

oder

$$a_1(U) = \text{gew}(U - U1),$$

$$a_2(U) = \text{gew}(U - U2),$$

wobei

$$gew(x) = \begin{array}{l} 0 \text{ für } x \le 0 \\ 1 \text{ für } 0 < x < 1 \\ 2 - \tfrac{1}{2} x \text{ für } 1 \le x \le 3 \\ \tfrac{1}{2} \text{ für } 3 < x. \end{array}$$

Dabei sind US, U1 und U2 geeignete Spannungsschwellenwerte.

Durch die vorliegende Erfindung wird nach alledem eine einfach und kostengünstig zu realisierende Vorgehensweise zur Ermittlung des Zustands einer Fahrzeugbatterie und damit auch des Bordnetzzustandes eines Fahrzeugs zur Verfügung gestellt. Dabei wird die Batteriespannung gemessen und einer Auswerteeinheit zugeführt. In dieser erfolgt ein Integrationsvorgang, bei welchem ein variabler Gewichtungsfaktor berücksichtigt wird. Der Gewichtungsfaktor kann ausschließlich von der gemessenen Batteriespannung oder zusätzlich auch von weiteren Größen abhängig sein.

**Patentansprüche**

1. Verfahren zur Ermittlung des Zustands einer Fahrzeugbatterie, bei welchem eine Messung der Batteriespannung erfolgt und aus der gemessenen Batteriespannung mittels eines Integrationsvorganges Informationen über den Zustand der Fahrzeugbatterie abgeleitet werden, **dadurch gekennzeichnet, dass** beim Integrationsvorgang ein variabler Gewichtungsfaktor berücksichtigt wird.

2. Verfahren nach Anspruch 1, **dadurch gekennzeichnet , dass** der Gewichtungsfaktor von der gemessenen Batteriespannung abhängig ist.

3. Verfahren nach Anspruch 2, **dadurch gekennzeichnet , dass** der Gewichtungsfaktor gemäß folgender Beziehung berechnet wird:

$$a(U) = \sum_{i=1}^{n} k_i \bullet a_i(U),$$

wobei $k_i$ Vorfaktoren sind, die adaptiv variiert werden, und $a_i(U)$ Gewichtsfunktionen sind.

4. Verfahren nach Anspruch 3, **dadurch gekennzeichnet , dass** die Vorfaktoren in Abhängigkeit von Statusinformationen adaptiert werden.

5. Verfahren nach Anspruch 4, **dadurch gekennzeichnet , dass** die Statusinformationen unter Verwendung einer Ruhespannungsmessung, unter Verwendung von von einem elektrischen Energiemanagement gelieferten Signalen, unter Verwendung von Informationen über auftretende Lastsprünge und/oder unter Verwendung von Informationen über auftretende Spannungseinbrüche ermittelt werden.

6. Verfahren nach Anspruch 2, **dadurch gekennzeichnet , dass** ein oberer Spannungsschwellenwert (U1) und ein unterer Spannungsschwellenwert (U2) vorgegeben werden und der Gewichtungsfaktor nach folgender Beziehung ermittelt wird:

   - liegt der gemessene Batteriespannungswert zwischen den beiden Spannungsschwellenwerten, dann hat der Gewichtungsfaktor den Wert 0;
   - ist der gemessene Batteriespannungswert kleiner als der untere Spannungsschwellenwert (U2) oder größer als der obere Spannungsschwellenwert (U1), dann hat der Gewichtungsfaktor den Wert 1.

7. Verfahren nach einem der vorhergehenden Ansprüche, **dadurch gekennzeichnet, dass** im Rahmen des Integrationsvorganges eine Differenzbildung erfolgt, bei welcher die Hälfte der Summe der beiden Spannungsschwellenwerte von der gemessenen Batteriespannung subtrahiert wird.

8. Verfahren nach Anspruch 7, **dadurch gekennzeichnet, dass** zur Ermittlung der Informationen über den Zustand der Fahrzeugbatterie folgende Beziehung verwendet wird:

$$L(t) = \int_{t_0}^{t} D(\tau) \bullet a[U(\tau)]d\tau,$$

wobei gilt:

$$D(\tau) = U(\tau) - \frac{U1 + U2}{2},$$

und wobei L(t) die ermittelte Batteriespannung, D($\tau$)eine Differenzfunktion, a[U($\tau$)] der Gewichtungsfaktor, U1 der obere Spannungsschwellenwert und U2 der untere Spannungsschwellenwert ist.

9. Vorrichtung zur Ermittlung des Zustands einer Fahrzeugbatterie, mit

   - einem Batteriespannungsmesser (1) und
   - einer mit dem Batteriespannungsmesser (1) verbundenen Auswerteeinheit (2), mittels welcher unter Verwendung der gemessenen Batteriespannung mittels eines Integrationsvorganges Informationen über den Zustand der Fahrzeugbatterie ableitbar sind,

   **dadurch gekennzeichnet, dass**

   - die Auswerteeinheit (2) beim Integrationsvorgang einen variablen Gewichtungsfaktor berücksichtigt.

10. Vorrichtung nach Anspruch 9, **dadurch gekennzeichnet , dass** die Auswerteeinheit (2) zur Berechnung des Gewichtungsfaktors nach folgender Beziehung vorgesehen ist:

$$a(U) = \sum_{i=1}^{n} k_i \bullet a_i(U),$$

wobei $k_i$ Vorfaktoren sind, die adaptiv variiert werden, und $a_i(U)$ Gewichtsfunktionen sind.

11. Vorrichtung nach Anspruch 10, **dadurch gekennzeichnet , dass** die Auswerteeinheit (2) mindestens einen Eingang für Statusinformationen aufweist und zur Adaption der Vorfaktoren in Abhängigkeit von den Statusinformationen vorgesehen ist.

12. Vorrichtung nach Anspruch 9, **dadurch gekennzeichnet , dass** die Auswerteeinheit (2) zur Berechnung des Gewichtungsfaktors nach folgender Beziehung vorgesehen ist:

$$a(U) = \begin{cases} 0 \ \text{für } U2 \leq U \leq U1 \\ 1 \ \text{für } U2 > U \ \text{oder } U1 < U. \end{cases}$$

wobei U1 ein vorgegebener oberer Spannungsschwellenwert und U2 ein vorgegebener unterer Spannungsschwellenwert ist.

**13.** Vorrichtung nach einem der Ansprüche 9 - 12, **dadurch gekennzeichnet, dass** die Auswerteeinheit (2) zur Durchführung folgender Differenzbildung vorgesehen ist:

$$D(\tau) = U(\tau) - \frac{U1 + U2}{2},$$

wobei U1 ein vorgegebener oberer Spannungsschwellenwert, U2 ein vorgegebener unterer Spannungsschwellenwert und U($\tau$) ein gemessener Batteriespannungswert ist.

**14.** Vorrichtung nach Anspruch 13, **dadurch gekennzeichnet , dass** die Auswerteeinheit (2) zur Durchführung des folgenden Integrationsvorganges vorgesehen ist:

$$L(t) = \int_{to}^{t} D(\tau) \bullet a[U(\tau)]d\tau.$$

FIG 1

FIG 2

EP 1 439 399 A2

FIG 3

FIG 4

10